# EUROPÄISCHE PATENTSCHRIFT

(11) **EP 1 696 481 B1**
(45) Veröffentlichungstag und Bekanntmachung des Hinweises auf die Patenterteilung: **23.04.2008**
(21) Anmeldenummer: 06002799.2
(22) Anmeldetag: 11.02.2006
(51) Int. Cl.: H01L 23/13, H01L 21/60, H01L 23/538, H01L 23/14

(54) **Verfahren zur Integration eines elektronischen Bauteils in einer Substratkavität**
Method of integrating an electronic component into a substrate cavity
Procédé d'intégration d'un dispositif électronique dans une cavité d'un substrat

(30) Priorität: 18.02.2005 DE 102005007423
(43) Veröffentlichungstag der Anmeldung: 30.08.2006
(73) Patentinhaber: ATMEL Germany GmbH, 74072 Heilbronn (DE)
(72) Erfinder: Joodaki, Mojtaba, Dr.-Ing., 81735 München (DE)
(74) Vertreter: Müller, Wolf-Christian

(56) Entgegenhaltungen:
- EP-A- 0 478 426
- DE-A1- 19 720 300
- US-A- 5 008 213
- US-A1- 2004 203 193
- JOODAKI M ET AL: "New generation quasi-monolithic integration technology (QMIT)" 2002 PROCEEDINGS 52ND. ELECTRONIC COMPONENTS AND TECHNOLOGY CONFERENCE. ECTC 2002. SAN DIEGO, CA, MAY 28 - 31, 2002, PROCEEDINGS OF THE ELECTRONIC COMPONENTS AND TECHNOLOGY CONFERENCE, NEW YORK, NY : IEEE, US, Bd. CONF. 52, 28. Mai 2002 (2002-05-28), Seiten 641-645, XP010747696 ISBN: 0-7803-7430-4

## Beschreibung

Die vorliegende Erfindung betrifft ein Verfahren zur Integration eines elektronischen Bauteils oder dergleichen in ein Substrat.

Die Bauelemente-Modellierung von auf einem Halbleitersubstrat integrierten Bauteilen nimmt mit steigender Betriebsfrequenz eine immer größer werdende Rolle ein, da in diesem Fall die Leitungseigenschaften, die Reflektionen an Diskontinuitäten, das Überlappen und die Verlustleistung zunehmen. Somit ist eine Berücksichtigung dieser Effekte in der Modellierung, insbesondere im Hochfrequenzbereich, im Allgemeinen unerlässlich. Insbesondere bei einem niederohmigen Substrat, wie beispielsweise einem Silizium-Substrat, ist der parasitäre Einfluss der Substratleitfähigkeit und zusätzlicher Kapazitäten nicht zu vernachlässigen.

Obwohl allgemein auf beliebige elektronische Bauteile anwendbar, werden die vorliegende Erfindung sowie die ihr zugrunde liegende Problematik vorzugsweise in Bezug auf einen in dem Substrat zu integrierenden Chip näher erläutert.

Die Integration von elektronischen Bauteilen in ein Halbleitersubstrat und die einzelnen Verkapselungen beeinflussen in erheblichem Maße die Leistung, die Kosten, die Zuverlässigkeit und die Lebensdauer des Bauelementes. Im Allgemeinen bestehen unverdrahtete Untersysteme aus verschiedenen Bauteilen, wie beispielsweise Hochfrequenz-Transceivern, digitale Prozessoren, MEM's oder dergleichen. Mikrowellen-Transceiver bestehen beispielsweise sowohl aus integrierten Schaltungen als auch aus passiven Bauelementen mit Filtern und Leistungselementen, welche nicht auf dem Halbleitersubstrat integriert sind. Diese Bauteile basieren auf verschiedenen Materialien und Technologien.

In der Vergangenheit wurden erhebliche Verbesserungen bei der Herstellung und den Charakteristiken von elektronischen Bauteilen erreicht und etliche neue Bauteile wurden entwickelt. Die Entwicklung von Verbindungshalbleitern, wie beispielsweise Gallium-Arsenid, Indium-Phosphid oder dergleichen, und von 3-fach Verbindungshalbleitern hat die Schaffung von Mikrowellen- und Millimeterwellenbauteilen mit einer exzellenten Rausch- und Leistungscharakteristik ermöglicht. Die Mikrobearbeitung im Radiofrequenzbereich und MEM's haben sich als die Technologien herausgestellt, die einen großen Einfluss auf bestehende Architekturen im Radiofrequenzbereich, beispielsweise bei Sensoren wie insbesondere Radarsensoren, und im Kommunikationsbereich erzielen könnten, in dem sie das Gewicht, die Kosten, die Größe und die Verlustleistung reduzieren. Die dazu notwendigen Technologien stehen mittlerweile zur Verfügung.

In der Vergangenheit wurden viele Hochleistungsbauteile geschaffen, welche in ein Halbleitersubstrat zu integrieren sind und ohne einer Leistungsverminderung eingekapselt werden können. Dabei kann ein gesamtes Bauelement aus mehreren einzelnen Bauteilen bestehen, die nach und nach ineinander verkapselt werden, wobei ein derartiges verkapseites System als SOP (System On a Package)-System bezeichnet wird. Eine Hauptaufgabe bei den SOP-Systemen besteht darin, einzelne Bauelemente oder Chips in ein Trägersubstrat - als quasi erste Ebene der Verkapselung - zu integrieren.

Im Stand der Technik finden sich mehrere Verfahren zur Integration von einzelnen Chips aus verschiedenen Materialien auf einem oder in ein Substrat. Die gängigsten Verfahren sind als Bond- oder Flip-Chip-Technologie bekannt.

Unter Bonden versteht man die Montage von beispielsweise Chips auf einem Chipträger, wobei ein einzelner Chip beispielsweise in einem Chipbonder mittels eines Epoxydklebers auf einen Chipträger geklebt wird. Zur elektrischen Verbindung der Kontaktgebiete der Chips (Bond-Pads) mit den zugeordneten Kontaktbahnen des Substrates dienen meist Aluminium- oder Golddrähte.

Beim Wedge-Bonden wird der Bonddraht horizontal über die Bondfläche gehalten und von einem keilförmigen Werkzeug abgequetscht - wobei der überschüssige Draht weggezogen wird-.

Beim Ball-Point-Bonden wird am Ende des Bonddrahtes mit Hilfe beispielsweise einer Wasserstoffflamme oder eines elektrischen Funkens eine Kugel gebildet. Die verwendeten Drähte weisen ungefähr einen Durchmesser von 10 bis 25 µm auf. Diese sehr dünnen Drähte weisen eine hohe Induktivität bei höheren Frequenzen auf. Ferner verursachen Veränderungen ihrer Drahtlängen und ihrer gebogenen Formen nachteilig unterschiedliche Leistungen in Abhängigkeit des jeweiligen Moduls.

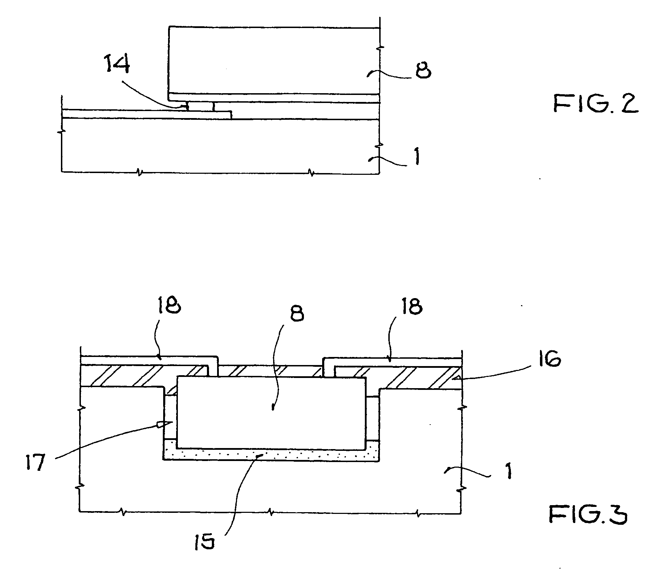

Ferner ist gemäß dem Stand der Technik die Flip-Chip-Technologie bekannt. Bei der Flip-Chip-Technologie, wie in Figur 2 dargestellt ist, wird der Chip 8 in Richtung nach unten auf das Substrat 1 aufgebracht. Lothügel 14 und beispielsweise mit Leitpulver gefüllte Klebeverbindungen dienen hierbei als Verbindungsmittel, wodurch eine gute elektrische Verbindung gewährleistet wird. Der thermische Pfad verläuft direkt über das Substrat 1.

An diesem Ansatz gemäß dem Stand der Technik hat sich jedoch die Tatsache als nachteilig herausgestellt, dass sich beispielsweise für den Fall von Hochleistungs-Gallium-Arsenid-MMIC's dieser thermische Pfad als üblicher Weise ungenügend für einen zuverlässigen Betrieb erweist, so dass zusätzliche thermische Ableitungen vorgesehen werden müssen. Ferner ist an diesem Ansatz nachteilig, dass die thermischen Ausdehnungskoeffizienten der einzelnen verwendeten Materialien unterschiedlich ausgebildet sind, wodurch die Lebensdauer des Bauelementes reduziert wird.

Es wurden ferner Unternehmungen dahingehend getätigt, neue Verfahren für eine zuverlässige Integration von auf verschiedenen Materialien basierenden Chips auf einem oder in ein Silizium-Substrat zu entwickeln. In Figur 3 ist eine schematische Querschnittsansicht eines in einem Substrat 1 integrierten elektronischen Bauteils 8 illustriert. Das Substrat 1 wird von der Vorderseite her geätzt und der Chip 8 in die geätzte Kavität mittel eines thermisch leitfähigen Klebers befestigt.

Zudem wird eine organische dielektrische Schicht auf der Vorderseite des Substrates 1 aufgeschleudert, um die Oberfläche des gesamten Wafers ebenflächig auszugestalten. Wie in Figur 3 ferner ersichtlich ist, sind auf der organischen, dielektrischen Schicht 16 geeignete Metallisierungen 18, für eine elektrische Kontaktierung des Chips 8 vorgesehen.

An diesem Ansatz gemäß dem Stand der Technik hat sich jedoch die Tatsache als nachteilig herausgestellt, dass eine genaue Steuerung der Tiefe der vertikal geätzten Kavität in dem Substrat 1 schwer zu realisieren ist. Die meisten standardmäßigen Halbleiterherstellungsverfahren erfordern einen maximalen Höhenunterschied zwischen der Chipoberfläche und der Waferoberfläche von 2 µm. Trotz der Verwendung der aufgeschleuderten organischen dielektrischen Schicht 16 kann eine elektrische Verbindung zu dem Chip 8 hergestellt werden, jedoch ist eine planare Struktur wünschenswerter.

Ein weiterer, diesem Stand der Technik innewohnender Nachteil besteht darin, dass unterschiedliche Chips mit unterschiedlichen Bauhöhen unterschiedliche Kavitätstiefen erfordern, so dass Komplexe und aufwendige Ätzverfahren verwendet werden müssen.

Zudem besteht ein Nachteil in dem hohen thermischen Widerstands des Aufbaus gemäß Figur 3. Obwohl normalerweise ein thermisch leitfähiger Kleber oder ein Epoxid bei diesen Verfahren verwendet wird, weisen diese Materialien eine wesentlich niedrigere thermische Leitfähigkeit auf als Silizium oder Metalle, wie beispielsweise Gold oder Kupfer. Bei dem Auftreten eines Luftspaltes 17 zwischen dem Chip 8 und dem Substrat 1, wie in Fig. 3 dargestellt ist, kann der thermische Widerstand des gesamten Aufbaus sogar einen noch höheren Wert annehmen.

Da thermisch leitfähige Kleber und Epoxide hohe thermische Ausdehnungskoeffizienten aufweisen, weist der in Figur 3 dargestellte Aufbau eine große thermo-mechanische Spannung auf, welche die Lebensdauer des gesamten Bauelementes nachteilig erheblich verringert.

Gemäß einem weiteren Stand der Technik ist die sogenannte "Enhanced Quasi-Monolithic Integration Technologie (QMIT)" bekannt, welche als organisch abgeschiedenes Mehrfach-Chip-Modul (MCM-D) angesehen werden kann. Diese Technologie verwendet eine gemeinsame und als Dünnfilm ausgebildete Verbindung für das erste Level der Verkapselung bzw. Packaging. Bekannt ist aus "New generation quasi-monolithic integration technology (QMIT)" Jodaki M et al 2002 Proceedings 52nd. Electronic componentes and technology conference. ECTC 2002. San Diego, CA, May 28-31, 2002, Proceedings of the electronic components and technology conference, New York, NY,: IEEE, US, Bd. Conf. 52, 28. Mai 2002 (2002-05-28), Seiten 641 - 645, XP010747696 ISBN: 0-7803-7430-4) dahingehend ein Verfahren zur Integration elektrischer Bauteile, welches insbesondere die Verfahrensschritte des Bildens einer Siliziumdioxodschicht, des Ätzens von Kavitäten in diese Schicht, des Platzierens von Transistoren sowie ferner des Fixierens dieser Bauteile. Da diese Technologie sich in ihrem Anfangsstadium befindet, werden augenblicklich viele Bestrebungen unternommen, diese Technologie weiter zu verbessern.

Somit ist es Aufgabe der vorliegenden Erfindung, ein Verfahren zur Integration eines elektronischen Bauteils in ein Substrat zu schaffen, welches die oben genannten Nachteile beseitigt und im Vergleich zu gängigen Verfahren eine einfachere und kostengünstigere Integration eines elektronischen Bauteils in ein Substrat sowie eine verbesserte Wärmeableitung gewährleistet.

Die der vorliegenden Erfindung zugrunde liegende Idee besteht darin, dass das Verfahren zur Integration eines elektronischen Bauteils oder dergleichen in ein Substrat folgende Verfahrensschritte aufweist: Bilden einer dielektrischen Isolationsschicht auf der Vorderseite eines Substrates; Vollständiges Zurückätzen eines Bereiches des Substrates von der Rückseite des Substrates her zum Bilden einer Kavität; Bilden einer Photolackschicht in der Kavität des Substrates; Anordnen des elektronischen Bauteils auf die in der Kavität gebildete Photolackschicht für ein Anhaften des elektronischen Bauteils an der Photolackschicht; Entfernen der gebildeten Photolackschicht mit Ausnahme des Bereiches, an welchem das elektronische Bauteil auf der Photolackschicht in der Kavität anhaftet; und Bilden einer Fixierschicht über der Rückseite des Substrates zum Fixieren des elektronischen Bauteils in der Kavität des Substrates.

Somit weist die vorliegende Erfindung gegenüber dem Stand der Technik den Vorteil auf, dass durch ein einfaches und kostengünstiges Verfahren ein elektronisches Bauteil oder dergleichen in ein herkömmliches Siliziumsubstrat integriert werden kann, wobei das elektronische Bauteil durch die elektrischen Isolationsschichten abgedeckt und von der Fixierschicht gestützt wird.

Zudem ist aufgrund der kompakten Integration bei vereinfachten Herstellungsschritten ein kostengünstiges Verfahren gewährleistet, das mit den gängigen Halbleitertechnologien zum Bilden von analogen oder digitalen Schaltungen, wie beispielsweise der Si-MOS-Technologie, der SiGe-HBT-Technologie und der III-V-Compound-Halbleiter-Technologie, kompatibel ist.

In den Unteransprüchen finden sich weitere vorteilhafte Ausgestaltungen und Verbesserungen des im Patentanspruch 1 angegebenen Verfahrens.

Gemäß einer bevorzugten Weiterbildung ist das Substrat als Silizium-Halbleitersubstrat, Gallium-Arsenid-Halbleitersubstrat oder dergleichen ausgebildet. Selbstverständlich können irgendwelche geeigneten Halbleitermaterialien verwendet werden, welche anisotrop geätzt werden können.

Gemäß einer weiteren bevorzugten Weiterbildung wird die auf der Vorderseite des Substrates gebildete dielektrische Isolationsschicht aus einer ersten, einer zweiten und einer dritten dielektrischen Isolationsschicht ausgebildet. Ferner wird vorzugsweise eine vierte dielektrische Isolationsschicht auf der Rückseite des Substrates gebildet. Alle dielektrischen Isolationsschichten werden mit Ausnahme der zweiten dielektrischen Isolationsschicht vorzugsweise jeweils aus einem anorganischen lsolationsmaterial, beispielsweise einem Siliziumoxid, wie insbesondere Siliziumdioxid, einem Siliziumnitrid oder dergleichen hergestellt. Diese dielektrischen Materialien sind für anisotopische Nassätzverfahren besonders geeignet.

Gemäß einem weiteren bevorzugten Ausführungsbeispiel wird die zweite dielektrische Isolationsschicht aus einem organischen lsolationsmaterial, wie insbesondere Benzozyclobuthen (BCB), einem Polyimid, SU-8 oder dergleichen hergestellt. Diese organischen Isolationsmaterialien können vorteilhaft auf einfache Weise gegebenenfalls wieder entfernt werden.

Vorzugsweise wird das vollständige Zurückätzen eines Bereiches des Substrates mittels eines anistopen Verfahrens, beispielsweise mittels eines anistopen Nassätzverfahrens, durch vorheriges Strukturieren der vierten dielektrischen Isolationsschicht ausgeführt.

Gemäß einer weiteren bevorzugten Weiterbildung werden die dritte und vierte dielektrische Isolationsschicht sowie der sich an dem Boden der Kavität befindliche Bereich der ersten dielektrischen Isolationsschicht mittels eines geeigneten Verfahrens vor dem Bilden der Photolackschicht entfernt. Dadurch werden die Substratbereiche freigelegt, auf welche die Photolackschicht aufgebracht werden soll. Die Photolackschicht kann beispielsweise durch ein Aufschleuderverfahren, ein Sprühverfahren oder dergleichen mit einer homogenen Dicke gebildet werden.

Gemäß einem weiteren bevorzugten Ausführungsbeispiel wird das elektronische Bauteil als Chip, Transistor, Schaltung, MEMS oder dergleichen ausgebildet. Es ist für einen Fachmann offensichtlich, dass durch das erfindungsgemäße Verfahren beliebige elektronische Bauteile vorteilhaft in einem Halbleitersubstrat integriert werden können.

Das elektronische Bauteil wird vorzugsweise mittels einer Fine-Placer-Maschine auf der Photolackschicht in der Kavität des Substrates angeordnet. Vorteilhaft wird die Photolackschicht nach dem Anordnen des elektronischen Bauteils auf dieser mittels eines Temperaturverfahrens ausgehärtet. Das Entfernen der Photolackschicht in den Bereichen außerhalb des elektronischen Bauteils wird vorzugsweise mittels eines Trokkenätzverfahrens ausgeführt.

Gemäß einer weiteren bevorzugten Weiterbildung wird die Fixierschicht zum Fixieren des elektronischen Bauteils in der Kavität des Substrates mit einer homogenen Dicke und aus einem dielektrischen Material, insbesondere einem amorphen Siliziummaterial, oder aus einem metallischen Material, insbesondere aus Chrom oder Platin, hergestellt. Diese Materialien sind besonders geeignet für Kupfer- oder Gold-Galvanisierungsverfahren mit sehr guten Anhafteigenschaften.

Nach einem weiteren bevorzugten Ausführungsbeispiel werden nach dem Bilden der Fixierschicht die zweite dielektrische Isolationsschicht sowie der restliche Bereich der Photolackschicht mittels eines geeigneten Verfahrens entfernt. Danach wird vorzugsweise eine fünfte dielektrische Isolationsschicht, insbesondere aus einem organischen Isolationsmaterial, wie beispielsweise Benzozyclobuthen (BCB), Polyimid, SU-8 oder dergleichen, über der Vorderseite Substrates gebildet.

Zum Verbinden des Chips bzw. des elektronischen Bauteils mit einer weiteren Schaltung oder dergleichen wird die fünfte dielektrische Isolationsschicht strukturiert. Mit Hilfe dieser Strukturierung kann eine beliebige Metallisierung anschließend gebildet werden.

Nach einem weiteren bevorzugten Ausführungsbeispiel wird der freie Bereich der Kavität in dem Substrat am Ende des Integrationsverfahrens durch ein Füllmaterial aufgefüllt. Als Füllmaterial kann beispielsweise ein mit Diamantpulver gefülltes Polyimid verwendet werden. Dieses Material weist besonders vorteilhafte thermische Leitfähigkeiten, d. h. einen hohen thermischen Leitfähigkeitskoeffizienten auf, so dass die Wärme aus der Anordnung gut zu der Umgebung abgeleitet wird.

Nachfolgend werden bevorzugte Ausführungsbeispiele der vorliegenden Erfindung unter Bezugnahme auf die Figuren der Zeichnungen näher erläutert. Von den Figuren zeigen:
- Figur 1a-1k: Querschnittsansichten verschiedener Verfahrenszustände eines Verfahrens zur Integration eines Chips in ein Substrat gemäß einem bevorzugten Ausführungsbeispiel der vorliegenden Erfindung zur Illustration der einzelnen Verfahrenschritte;
- Figur 2: eine schematische Ansicht eines Flip-Chip-Verfahrens gemäß dem Stand der Technik; und
- Figur 3: eine Querschnittsansicht eines in ein Substrat integrierten Chips gemäß einem Stand der Technik.

In den Figuren bezeichnen gleiche Bezugszeichen gleiche oder funktionsgleiche Komponenten, soweit nichts Gegenteiliges angegeben ist.

Es sei an dieser Stelle darauf hingewiesen, dass in den Figuren weitere Schaltungen oder Bauteile auf dem Substrat aus Gründen der Übersichtlichkeit nicht mit dargestellt sind.

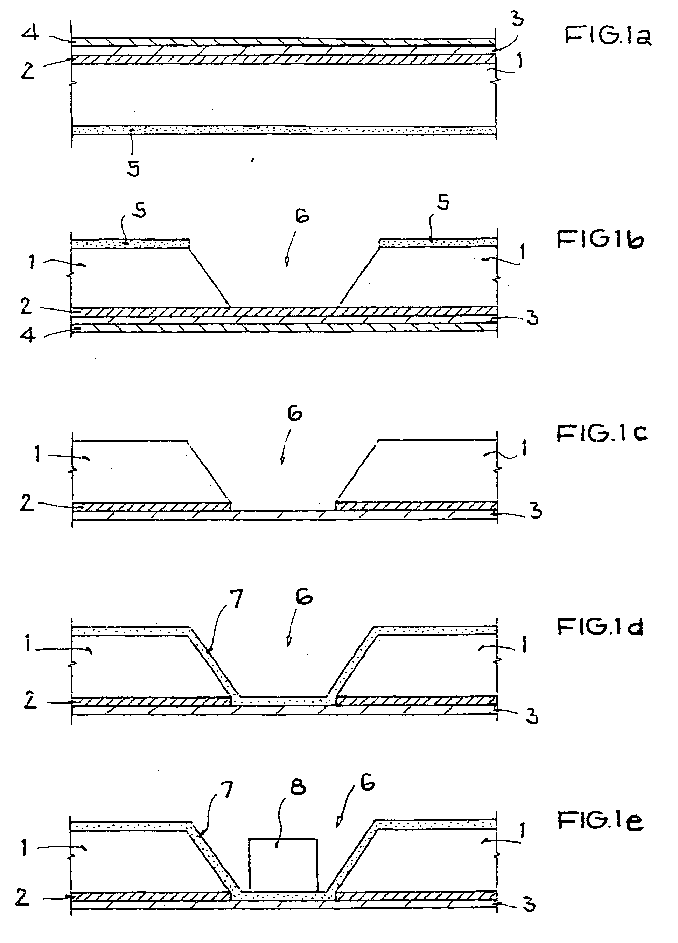

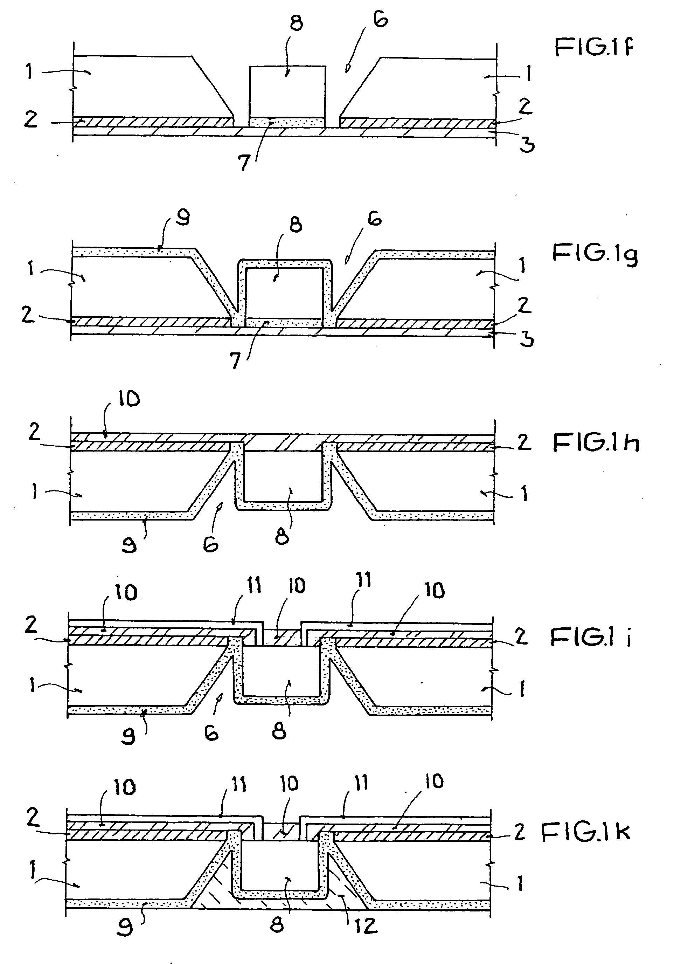

Die Figuren 1a-1k illustrieren Querschnittsansichten von einzelnen Verfahrenszuständen während eines Herstellungsverfahrens zum Integrieren eines elektronischen Bauteils 8 in ein Substrat 1 gemäß einem bevorzugten Ausführungsbeispiel der vorliegenden Erfindung.

Es sei an dieser Stelle darauf hingewiesen, dass die Orientierung der Anordnung in den Figuren 1a, 1i und 1k derart gewählt ist, dass die Vorderseite des Substrates 1 in Richtung nach oben ausgerichtet ist. Andererseits ist die Darstellung der Figuren 1b-1g derart gewählt, dass die Rückseite des Substrates 1 in Richtung nach oben ausgerichtet ist. Diese Ansichten sind entsprechend einer günstigen Ausrichtung des Substrates 1 bezüglich der einzelnen Verfahrensschritte gewählt, wobei mittels einer geeigneten Substrat-Trägereinrichtung ein Drehen des Substrates 1 für die unterschiedlichen Verfahrensschritte bewerkstelligt werden kann.

Als Trägersubstrat 1 wird beispielsweise ein niederohmiges Silizium-Halbleitersubstrat, ein Gallium-Arsenid-Substrat oder irgendein anderes Halbleitersubstrat verwendet, welches anisotropisch geätzt werden kann.

Wie in Figur 1a ersichtlich ist, werden auf der Vorderseite des Substrates 1 zunächst drei dielektrische Isolationsschichten 2, 3 und 4 gebildet. Die erste und dritte dielektrische Schicht 2 und 4 können beispielsweise als SiliziumNitrid-Schicht oder als Siliziumdioxid-Schicht ausgebildet werden. Bei diese Materialien handelt es sich für eine Maskierung bei einem anistropen Nassätzen von Silizium um vorteilhafte Materialien.

Die zweite dielektrische Schicht 3 ist vorzugsweise als Hilfsschicht 3 aus einem organischen Dielektrikum gebildet. Die zweite dielektrische Isolationsschicht 3 ist vorzugsweise aus einem derartigen Material und derart auf der ersten dielektrischen Isolationsschicht 2 gebildet, dass sie mittels eines geeigneten Verfahrens entfernt werden kann. Ferner dient die zweite dielektrische Schicht 3 als Trägermembran für ein etwaig eingesetztes elektronisches Bauteil, so dass deren Schichtdicke zum Tragen des eingesetzten elektronischen Bauteils dick genug ausgebildet werden sollte, um Brüche der zweiten dielektrischen Isolationsschicht 3 zu vermeiden. Die zweite dielektrische Schicht 3 besteht beispielsweise aus einem Polyimid, aus einem organischen Polymer-Material, insbesondere Benzozyclobuthen (BCB), einem SU-8 Material oder dergleichen, und kann mit einer Dicke von beispielsweise 10 µm bis 20 µm zum vorübergehenden Tragen eines Chips ausgebildet werden.

Wie in Figur 1a ferner illustriert ist, wird auf der Rückseite des Substrates 1 eine vierte dielektrische Isolationsschicht 5 aufgebracht, die analog zur ersten und dritten dielektrischen Isolationsschicht 2 und 4 vorzugsweise aus einem anorganischen lsolationsmaterial, beispielsweise einem Siliziumdioxid, einem Silziumnitrid oder dergleichen hergestellt ist.

Nachfolgend, wie in Figur 1b illustriert ist, wird eine Kavität 6 von der Rückseite des Substrates 1 her in das Substrat 1 geätzt. Der Ätzvorgang kann beispielsweise auf herkömmliche Weise mittels eines standardmäßigen KOH-Nassätzverfahrens ausgeführt werden. Für das Zurückätzen des Substrates 1 wird vorher die vierte dielektrische Isolationsschicht 5 in an sich bekannter und geeigneter Weise auf der Rückseite des Substrates 1 strukturiert. Der Ätzvorgang wird vorteilhaft derart ausgeführt, dass die dielektrischen Isolationsschichten 2, 3 und 4 auf der Vorderseite des Substrates 1 bei dem oben genannten Nassätzverfahren unbeschädigt bleiben. Daher ergibt sich die in Figur 1b dargestellte Kavität 6 in dem Substrat 1.

Danach werden unter Bezugnahme auf Figur 1c die vierte dielektrische Schicht 5 auf der Rückseite des Substrates 1 und die dritte dielektrische Isolationsschicht 4 sowie der Bereich der ersten dielektrischen Schicht 2 entfernt, welcher von der Öffnung der Kavität 6 her zugänglich ist. Dies kann beispielsweise mittels eines isotropen Trockenätzverfahrens bewerkstelligt werden. Dadurch ergibt sich die in Figur 1c dargestellte Struktur, wobei die zweite dielektrische Isolationsschicht 3 die zurückgeätzte Kavität 6 des Substrates 1 von der Vorderseite des Substrates 1 her abdeckt.

Als nächstes wird, wie in Figur 1d illustriert ist, eine Photolackschicht 7 über der Rückseite des Substrates 1 abgeschieden. Beispielsweise wird ein positiver Photolack 7 mittels eines standardmäßigen Aufschleuderverfahrens oder eines Sprühverfahrens über der Rückseite des Substrates 1 aufgebracht. Es ist für einen Fachmann offensichtlich, dass anstelle eines positiven Photolacks auch ein negativer Photolack mit entsprechend zugeordneten Verfahrensschritten verwendet werden kann

Die Photolackschicht 7 wird vorzugsweise mit einer homogenen Dicke über der Rückseite des Substrates 1 abgeschieden, wie in Figur 1d dargestellt ist.

In einem anschließenden Verfahrensschritt gemäß Figur 1e wird das zu integrierende elektronische Bauteil, vorliegend beispielsweise ein Chip 8 von der Rückseite des Substrates 1 her in die Kavität 6 derart eingesetzt, dass es auf der Photolackschicht 7 am Boden der Kavität 6 aufliegt und an dieser anhaftet.

Das elektronische Bauteil 8 kann anstelle eines Chips auch als Schaltungsteil, als Transistor, als MEM oder dergleichen ausgebildet sein. Es ist für einen Fachmann offensichtlich, das ein irgendwie geartetes Bauteil, beispielsweise ein passives oder aktives Bauteil, durch den vorliegenden Erfindungsgedanken in einem Substrat integriert werden kann. Im Folgenden wird jedoch weiter das Ausführungsbeispiel der vorliegenden Erfindung unter Verwendung eines Chips 8 erläutert.

Der Chip 8 kann beispielsweise unter Verwendung einer Fine-Placer-Maschine oder eines weiteren geeigneten Werkzeugs genau an der gewünschten Stelle in der Kavität 6 eingesetzt werden. Derartige Fine-Placer-Maschinen sind dem Fachmann hinlänglich bekannt und werden nicht detaillierter erläutert.

Die Photolackschicht 7 wird anschließend beispielsweise bei einer Temperatur von 60 C bis 90°C für eine längere Zeitdauer, beispielsweise für mehr als 20 Minuten, gebacken. In diesem Fall wird die Photolackschicht Schicht 7 für die nachfolgenden Schritte genügend getrocknet und kann später, wie im Folgenden beschreiben wird, auf einfache Weise wieder entfernt werden.

Nachfolgend, wie in Figur 1f illustriert ist, wird die Photolackschicht 7 mittels beispielsweise eines Trockenätzverfahrens von der Rückseite des Substrates 1 entfernt. Einzig und allein in dem Bereich, in welchem der Chip 8 auf der Photolackschicht 7 aufsitzt und an dieser anhaftet, wird die Photolackschicht 7 nicht zurückgeätzt. Dabei ergibt sich die in Figur 1f dargestellte Anordnung.

In Figur 1g wird der anschließend ausgeführte Verfahrensschritt illustriert. Hierbei wird eine Fixierschicht 9 von der Rückseite des Substrates 1 her über dem Substrat 1 aufgebracht. Die Fixierschicht 9 dient einem Fixieren des Bauteils 8 in der Kavität 6 des Substrates 1. Die Fixierschicht 9 wird vorzugsweise mit einer homogenen Dicke ausgebildet, wie in Figur 1g ersichtlich ist. Die Fixierschicht 9 ist vorzugsweise aus einem dielektrischen Material, insbesondere einem amorphen Silizium-Material, oder aus einem metallischen.Material hergestellt. Die Dicke der Fixierschicht 9 ist vorzugsweise derart gewählt, das eine sichere und stabile Fixierung des Chips 8 in der Kavität 6 gewährleistet ist. Ferner weist die Fixierschicht 9 vorzugsweise einen hohen Wärmeleitkoeffizienten auf, um Verlustwärme vorteilhaft aus der Anordnung an die Umgebung ableiten zu können.

Für den Fall einer metallischen Schicht werden beispielsweise dürine Schichten aus Chrom und/oder Platin, jeweils vorzugsweise mit einer Dicke von weniger als 50 nm, unter Verwendung eines Verdampfungsverfahrens auf der Rückseite des Substrates 1 abgeschieden, wobei das Substrat 1 vorzugsweise in Richtung des Metallflusses geneigt und mittels der vorher bereits erläuterten Substrat-Trägereinrichtung mittels eines elektrischen Motors oder dergleichen in geeignete Lage drehbar ist.

Anschließend kann diese dünne Schicht aus Chrom und/oder Platin durch ein Galvanisierungsverfahren verdickt werden, je nach erforderlicher Dicke, die zum Fixieren des Bauteils 8 in der Kavität 6 erforderlich ist. Eine Chromschicht weist gute Haftungseigenschaft bezüglich des Siliziumsubstrates 1 auf und eine Platinschicht ist ein ausgezeichnetes Metall für eine Galvanisierung mit Kupfer oder Gold mit guten Anhafteigenschaften. Diese Art der Herstellung der Fixierschicht 9 eignet sich insbesondere für Hochleistungsanwendungen. Allerdings sind auch andere Methoden zur Herstellung einer geeigneten Fixierschicht vorstellbar.

Als nächstes, wie in Figur 1h dargestellt ist, wird nach der Fixierung des Chips 8 in der Kavität 6 die zweite dielektrische Isolationsschicht 3 und der verbliebene Rest der Photolackschicht 7 von der Vorderseite des Substrates 1 her mittels eines geeigneten Verfahrens entfernt.

Anschließend, wie ebenfalls in Figur 1h illustriert ist, wird eine fünfte dielektrische Isolationsschicht 10 über der Vorderseite des Substrates 1 abgeschieden, um eine ebene Fläche über dem gesamten Substrat 1 zu gewährleisten. Die fünfte dielektrische Isolationsschicht 10 wird beispielsweise aus einem organischen lsolationsmaterial, wie beispielsweise einem organischen Polymer-Material, insbesondere Benzozyclobuthen (BCB), einem Polyimid oder dergleichen gebildet.

Wie in Figur 1i illustriert ist, kann für eine elektrische Anbindung des Chips 8 an zugeordneten Schaltungen oder dergleichen die fünfte dielektrische Isolationsschicht 10 derart strukturiert werden, dass geeignete Metallisierungen 11 zum Gewährleisten eines geeigneten elektrischen Kontaktes mit zugeordneten Komponenten gebildet werden können. Für Mikrowellen- und Millimeterwellen-Anwendungen wird vorzugsweise eine organische dielektrische Isolationsschicht 10 mit einer größeren Dicke verwendet, um etwaige Substratverluste zu verringern.

Abschließend, wie in Figur 1k dargestellt ist, kann ein Dielektrikum 12 mit einer hohen thermischen Leitfähigkeit in die freien bereiche der Kavität 6 gefüllt werden. Beispielsweise kann als dielektrische Schicht 12 ein mit Diamantpulver-gefülltes Polyimid verwendet werden, welches einen hohen Wärmeleitkoeffizienten aufweist. Es ist für einen Fachmann offensichtlich, dass auf die zusätzliche dielektrische Isolationsschicht 10 unter Umständen auch verzichtet werden kann.

Obwohl die vorliegende anhand bevorzugter Ausführungsbeispiele vorstehend beschrieben wurde, ist sie darauf nicht beschränkt, sondern auf vielfältige Weise modifizierbar.

Beispielsweise werden mit der oben beschriebenen Anordnung bei Verwendung einer dicken amorphen Siliziumschicht als dielektrische Fixierschicht Koplanarleitungen und bei Verwendung von metallischen Schichten als Fixierschicht Mikrostreifenleitungen verwirklicht. Dies ist jedoch lediglich exemplarisch wiedergegeben, so dass für einen Fachmann offensichtlich ist, das beliebig geeignete Materialien und Ausgestaltungen zum Verwirklichen des vorliegenden Erfindungsgedankens möglich sind.

Beispielsweise kann die aus der ersten, zweiten und dritten dielektrischen Isolationsschicht bestehende dielektrischen Gesamtschicht mit einer eher kleineren oder größeren Dicke ausgebildet werden, in Abhängigkeit von dem in dem Substrat zu integrierenden Bauteil. Dicken und Materialien werden vorzugsweise derart gewählt, dass eine sichere und stabile Fixierung des Bauteils 8 in der Kavität des Substrates gewährleistet ist.

Ferner ist es für einen Fachmann offensichtlich, dass andere als die angegebenen Materialien, Schichtdicken und Bauteile verwendet werden können, ohne den vorliegenden Erfindungsgedanken zu verlassen.

### Bezugszeichenliste

- 1: Substrat
- 2: erste dielektrische Isolationsschicht
- 3: zweite dielektrische Isolationsschicht
- 4: dritte dielektrische Isolationsschicht
- 5: vierte dielektrische Isolationsschicht
- 6: Kavität
- 7: Photolackschicht
- 8: elektronisches Bauteil
- 9: Fixierschicht
- 10: organische dielektrische Isolationsschicht
- 11: Metallisierung
- 12: Polyimidschicht
- 13:
- 14: Lothügel
- 15: leitfähiger Kleber
- 16: organische dielektrische Schicht
- 17: Luftspalt
- 18: Metallisierung

## Patentansprüche

1. Verfahren zur Integration eines elektronischen Bauteils (8) oder dergleichen in eine Substrat (1) mit folgenden Verfahrensschritten:
- Bilden einer dielektrischen Isolationsschicht (2, 3, 4) auf der Vorderseite eines Substrates (1);
- Vollständiges Zurückätzen eines Bereiches des Substrates (1) von der Rückseite des Substrates (1) her zum Bilden einer Kavität (6);
- Bilden einer Photolackschicht (7) in der Kavität (6) des Substrates (1);
- Anordnen eines elektronischen Bauteils (8) auf die in der Kavität (6) gebildete Photolackschicht (7) für ein Anhaften des elektronischen Bauteils (8) an derselben;
- Entfernen der gebildeten Photolackschicht (7) außerhalb des Bereiches, an welchem das elektronische Bauteil (8) auf der Photolackschicht (7) der Kavität (6) anhaftet; und
- Bilden einer Fixierschicht (9) über der Rückseite des Substrates (1) zum Fixieren des elektronischen Bauteils (8) in der Kavität (6) des Substrates (1).

2. Verfahren nach Anspruch 1,
**dadurch gekennzeichnet,**
**dass** das Substrat (1) als Silizium-Halbleitersubstrat, Gallium-Arsenid-Halbleitersubstrat oder dergleichen ausgebildet wird.

3. Verfahren nach einem der vorstehenden Ansprüche,
**dadurch gekennzeichnet,**
**dass** die auf der Vorderseite des Substrates (1) gebildete dielektrische Isolationsschicht aus einer ersten dielektrischen Isolationsschicht (2), einer zweiten dielektrischen Isolationsschicht (3) und einer dritten dielektrischen Isolationsschicht (4) ausgebildet wird.

4. Verfahren nach Anspruch 3,
**dadurch gekennzeichnet,**
**dass** auf der Rückseite des Substrates (1) eine vierte dielektrische Isolationsschicht (5) vor dem Zurückätzen eines Bereiches des Substrats gebildet wird.

5. Verfahren nach Anspruch 4,
**dadurch gekennzeichnet,**
**dass** die dielektrischen Isolationsschichten (2, 4, 5) mit Ausnahme der zweiten dielektrische Isolationsschicht (3) jeweils aus einem anorganischen Isolationsmaterial, beispielsweise einem Siliziumoxid, wie insbesondere Siliziumdioxid, einem Siliziumnitrid oder dergleichen hergestellt werden.

6. Verfahren nach Anspruch 3 oder 5,
**dadurch gekennzeichnet,**
**dass** die zweite dielektrische Isolationsschicht (3) aus einem organischen lsolationsmaterial, insbesondere Benzozyclobuthen (BCB), einem Polyimid, SU-8 oder dergleichen hergestellt wird.

7. Verfahren nach Anspruch 4,
**dadurch gekennzeichnet,**
**dass** das vollständige Zurückätzen eines Bereiches des Substrates zum Bilden einer Kavität (1) mittels eines anisotropen Ätzverfahrens, beispielsweise mittels eines anisotopen Nassätzverfahrens, durch vorheriges Strukturieren der vierten dielektrischen Isolationsschicht (5) ausgeführt wird.

8. Verfahren nach Anspruch 4,
**dadurch gekennzeichnet,**
**dass** die dritte dielektrische Isolationsschicht (4) und die vierte dielektrische Isolationsschicht (5) sowie der sich am Boden der Kavität (6) befindliche Bereich der ersten elektrischen Isolationsschicht (2) mittels eines geeigneten Verfahrens vor dem Bilden der Photolackschicht (7) entfernt werden.

9. Verfahren nach wenigstens einem der vorhergehenden Ansprüche,
**dadurch gekennzeichnet,**
**dass** die Photolackschicht (7) durch ein Aufschleuderverfahren, ein Sprühverfahren oder dergleichen mit einer homogenen Dicke gebildet wird.

10. Verfahren nach wenigstens einem der vorhergehenden Ansprüche,
**dadurch gekennzeichnet,**
**dass** das elektronische Bauteil (8) als Chip, Transistor, Schaltung, MEMS oder dergleichen ausgebildet wird.

11. Verfahren nach wenigstens einem der vorhergehenden Ansprüche,
**dadurch gekennzeichnet,**
**dass** das elektronische Bauteil (8) mittels einer Fine-Placer-Maschine auf der Photolackschicht (7) der Kavität (6) des Substrates (1) angeordnet wird.

12. Verfahren nach wenigstens einem der vorhergehenden Ansprüche,
**dadurch gekennzeichnet,**
**dass** die Photolackschicht (7) nach dem Anordnen des elektronischen Bauteils (8) auf dieser mittels eines Temperaturverfahrens behandelt wird.

13. Verfahren nach wenigstens einem der vorhergehenden Ansprüche,
**dadurch gekennzeichnet,**
**dass** das Entfernen der Photolackschicht (7) mittels eines Trockenätzverfahrens ausgeführt wird.

14. Verfahren nach wenigstens einem der vorhergehenden Ansprüche,
**dadurch gekennzeichnet,**
**dass** die Fixierschicht (9) mit einer homogenen Dicke aus einem dielektrischen Material, insbesondere einem amorphen Siliziummaterial, oder aus einem metallischen Material, insbesondere aus Chrom und/oder Platin, hergestellt wird.

15. Verfahren nach Anspruch 8,
**dadurch gekennzeichnet,**
**dass** nach dem Bilden der Fixierschicht (9) die zweite dielektrische Isolationsschicht (3) sowie der vorher nicht zurückgeätzte Bereich der Photolackschicht (7) mittels eines geeigneten Verfahrens entfernt werden.

16. Verfahren nach Anspruch 15,
**dadurch gekennzeichnet,**
**dass** nach dem Entfernen der zweiten dielektrischen Isolationsschicht (3) sowie des vorher nicht zurückgeätzten Bereiches der Photolackschicht (7) eine fünfte dielektrische Isolationsschicht (10), insbesondere aus einem organischen Isolationsmaterial, wie beispielsweise Benzozyclobuthen (BCB), Polyimid, SU-8 oder dergleichen, über der Vorderseite des Substrates (1) gebildet wird.

17. Verfahren nach Anspruch 16,
**dadurch gekennzeichnet,**
**dass** die fünfte dielektrische Isolationsschicht (10) geeignet strukturiert und eine Metallisierung entsprechend der gebildeten Strukturierung gebildet wird.

18. Verfahren nach wenigstens einem der vorhergehenden Ansprüche,
**dadurch gekennzeichnet,**
**dass** der freie Bereich der Kavität (6) in dem Substrat (1) am Ende des Integrationsverfahren durch ein Füllmaterial (12) mit einem hohen Wärmeleitkoeffizienten, beispielsweise mit einem mit Diamantpulver gefüllten Polyimid, gefüllt wird.

## Claims

1. Method for integration of an electronic component (8) or the like in a substrate (1) by the following method steps:
- forming a dielectric insulation layer (2, 3, 4) on the front side of a substrate (1);
- complete etching back of a region of the substrate (1) from the rear side of the substrate (1) so as to form a cavity (6);
- forming a photoresist layer (7) in the cavity (6) of the substrate (1);
- arranging an electronic component (8) on the photoresist layer (7), which is formed in the cavity (6), for adhesion of the electronic component (8) thereto;
- removing the formed photoresist layer (7) outside the region at which the electronic component (8) adheres to the photoresist layer (7) of the cavity (6); and
- forming a fixing layer (9) over the rear side of the substrate (1) for fixing the electronic component (8) in the cavity (6) of the substrate (1).

2. Method according to claim 1, **characterised in that** the substrate (1) is formed as a silicon semiconductor substrate, gallium arsenide semiconductor substrate or the like.

3. Method according to one of the preceding claims, **characterised in that** the dielectric insulation layer formed on the front side of the substrate (1) is formed from a first dielectric insulation layer (2), a second dielectric insulation layer (3) and a third dielectric insulation layer (4).

4. Method according to claim 3, **characterised in that** a fourth dielectric insulation layer (5) is formed on the rear side of the substrate (1) prior to the etching back of a region of the substrate.

5. Method according to claim 4, **characterised in that** the dielectric insulation layers (2, 4, 5) with the exception of the second dielectric insulation layer (3) are each produced from an inorganic insulation material, for example a silicon oxide such as, in particular, silicon dioxide, a silicon nitride or the like.

6. Method according to claim 3 or 5, **characterised in that** the second dielectric insulation layer (3) is produced from an organic insulation material, especially benzocyclobuthene (BCB), a polyimide, SU-8 or the like.

7. Method according to claim 4, **characterised in that** the complete etching back of a region of the substrate for forming a cavity (1) is carried out by means of an anisotropic etching method, for example by means of anisotropic wet etching method, through previous structuring of the fourth dielectric insulation layer (5).

8. Method according to claim 4, **characterised in that** the third dielectric insulation layer (4) and the fourth dielectric insulation layer (5) as well as the region, which is disposed at the base of the cavity (6), of the first dielectric insulation layer (2) are removed by means of a suitable method prior to forming the photoresist layer (7).

9. Method according to at least one of the preceding claims, **characterised in that** the photoresist layer (7) is formed by a spin-on deposition method, a spray method or the like with a homogeneous thickness.

10. Method according to at least one of the preceding claims, **characterised in that** the electronic component (8) is constructed as a chip, transistor, circuit, MEMS or the like.

11. Method according to at least one of the preceding claims, **characterised in that** the electronic component (8) is arranged by means of a fine-placer machine on the photoresist layer (7) of the cavity (6) of the substrate (1).

12. Method according to at least one of the preceding claims, **characterised in that** the photoresist layer (7) is treated by means of a temperature method after arranging of the electronic component (8) on the layer.

13. Method according to at least one of the preceding claims, **characterised in that** the removal of the photoresist layer (7) is carried out by means of a dry etching method.

14. Method according to at least one of the preceding claims, **characterised in that** the fixing layer (9) is produced with a homogeneous thickness from a dielectric material, particularly an amorphous silicon material, or from a metallic material, particularly from chromium and/or platinum.

15. Method according to claim 9, **characterised in that** after forming the fixing layer (9) the second dielectric insulation layer (3) as well as the region, which was not previously etched back, of the photoresist layer (7) are removed by means of a suitable method.

16. Method according to claim 15, **characterised in that** after removal of the second dielectric insulation layer (3) as well as the region, which was not previously etched back, of the photoresist layer (7) a fifth dielectric insulation layer (10), particularly of an organic insulation material, such as, for example, benzocyclobuthene (BCB), polyimide, SU-8 or the like, is formed over the front side of the substrate (1).

17. Method according to claim 16, **characterised in that** the fifth dielectric insulation layer (10) is suitably structured and a metallisation is formed in correspondence with the formed structuring.

18. Method according to at least one of the preceding claims, **characterised in that** the free region of the cavity (6) in the substrate (1) is filled at the end of the integration method by a filling material (12) with a high coefficient of thermal conductivity, for example by a polyimide filled with diamond powder.

## Revendications

1. Procédé d'intégration d'un composant électronique (8) ou similaire dans un substrat (1) comprenant les étapes suivantes :
. constitution d'une couche isolante diélectrique (2,3,4) sur la face avant d'un substrat (1) ;
. décapage total par repoussage d'une zone du substrat (1) à partir de la face arrière du substrat (1) pour constituer une cavité (6) ;
. formation d'une couche de laque photosensible (7) dans la cavité (6) du substrat (1) ;
. mise en place d'un composant électronique (8) sur la couche de laque photosensible (7) constituée dans la cavité (6) pour y faire adhérer le composant électronique (8) ;
. suppression de la couche de laque photosensible (7) en dehors de la zone dans laquelle le composant électronique (8) adhère à la couche de laque photosensible (7) de la cavité (6), et
. formation d'une couche de fixation (9) au-dessus de la face arrière du substrat (1) pour fixer le composant électronique (8) dans la cavité (6) du substrat (1).

2. Procédé selon la revendication 1, **caractérisé en ce que** le substrat (1) est constitué sous la forme d'un substrat semi-conducteur au silicium, à l'arséniure de gallium ou similaire.

3. Procédé selon l'une quelconque des revendications précédentes, **caractérisé en ce que** la couche isolante diélectrique formée sur la face avant du substrat (1) est constituée d'une première couche isolante diélectrique (2), d'une deuxième couche isolante diélectrique (3) et d'une troisième couche isolante diélectrique (4).

4. Procédé selon la revendication 3, **caractérisé en ce que** l'on constitue sur la face arrière du substrat (1) une quatrième couche isolante diélectrique (5) avant gravure par repoussage d'une zone du substrat.

5. Procédé selon la revendication 4, **caractérisé en ce que** les couches isolantes diélectriques (2,4,5), à l'exception de la deuxième couche isolante diélectrique (3) sont chacune réalisées à partir d'un matériau isolant inorganique par exemple de l'oxyde de silicium tel que plus particulièrement du bioxyde de silicium, du nitride de silicium ou similaire.

6. Procédé selon la revendication 3 ou 5, **caractérisé en ce que** la deuxième couche isolante diélectrique (3) est réalisée à partir d'un matériau isolant organique, plus particulièrement du benzocyclobutène (BCB), du polyimide, du SU-8 ou similaire.

7. Procédé selon la revendication 4, **caractérisé en ce que** le décapage total par repoussage d'une zone du substrat (1) pour former une cavité est effectuée au moyen d'un procédé de gravure anisotrope, par exemple au moyen d'un procédé de gravure humide, en structurant au préalable la quatrième couche isolante diélectrique (5).

8. Procédé selon la revendication 4, **caractérisé en ce qu'**avant de constituer la couche de laque photosensible (7), on enlève la troisième couche isolante diélectrique (4) et la quatrième couche isolante diélectrique (5) ainsi que la zone située au fond de la cavité (6) de la première couche isolante électrique (2) au moyen d'un procédé approprié.

9. Procédé selon l'une au moins des revendications précédentes, **caractérisé en ce que** la couche de laque photosensible (7) est constituée par dépôt par projection ou pulvérisation ou similaire en une couche homogène.

10. Procédé selon l'une au moins des revendications précédentes, **caractérisé en ce que** le composant électronique (8) est réalisé sous la forme d'une puce, d'un transistor, d'un circuit, d'un système micro-électro-mécanique ou similaire.

11. Procédé selon l'une au moins des revendications précédentes, **caractérisé en ce que** le composant électronique (8) est disposé sur la couche de laque photosensible (7) de la cavité (6) du substrat (1) au moyen d'une machine à micro-placement.

12. Procédé selon l'une au moins des revendications précédentes, **caractérisé en ce que** la couche de laque photosensible (7) est traitée au moyen d'un procédé thermique après y avoir disposé le composant électronique (8).

13. Procédé selon l'une au moins des revendications précédentes, **caractérisé en ce que** la suppression de la couche de laque photosensible (7) est réalisée au moyen d'un procédé de gravure sèche.

14. Procédé selon l'une au moins des revendications précédentes, **caractérisé en ce que** la couche de fixation (9) est réalisée à épaisseur homogène à partir d'un matériau diélectrique, plus particulièrement un matériau de silicium amorphe, ou d'un matériau métallique, plus particulièrement du chrome et/ou du platine.

15. Procédé selon la revendication 8, **caractérisé en ce qu'**après formation de la couche de fixation (9) on enlève la deuxième couche isolante diélectrique (3) ainsi que la zone de la couche de laque photosensible (7) préalablement non décapée.

16. Procédé selon la revendication 15, **caractérisé en ce qu'**après avoir enlevé la deuxième couche isolante diélectrique (3) ainsi que la zone de la couche de laque photosensible (7) préalablement non décapée on constitue une cinquième couche isolante diélectrique (10), plus particulièrement à partir d'un matériau isolant organique tel que par exemple le benzocyclobutène (BCB), le polyimide, le SU-8 ou similaire, au-dessus de la face avant du substrat (1).

17. Procédé selon la revendication 16, **caractérisé en ce que** la cinquième couche isolante diélectrique (10) est structurée de manière appropriée et **en ce que** l'on effectue une métallisation correspondant à la structuration réalisée.

18. procédé selon l'une au moins des revendications précédentes, **caractérisé en ce qu'**à la fin du procédé d'intégration, la zone libre de la cavité (6) ménagée dans le substrat (1) est remplie d'un matériau de remplissage (12) à coefficient de conductivité thermique élevé, par exemple d'un polyimide rempli de poudre de diamant.
